# EUROPÄISCHE PATENTSCHRIFT

(11) **EP 0 899 869 B1**
(45) Veröffentlichungstag und Bekanntmachung des Hinweises auf die Patenterteilung: **30.08.2006**
(21) Anmeldenummer: 98110891.3
(22) Anmeldetag: 15.06.1998
(51) Int. Cl.: H03F 1/02, H03F 1/30

(54) **Verfahren und Schaltungsanordnung zur Einstellung eines Arbeitspunktes einer Transistorstufe**
Method and circuit for biasing a transistor stage
Méthode et circuit pour la polarisation d'un étage à transistor

(30) Priorität: 26.08.1997 DE 19737062
(43) Veröffentlichungstag der Anmeldung: 03.03.1999
(73) Patentinhaber: BenQ Corporation, Gueishan Taoyuan 333 (TW)
(72) Erfinder: Treufels, Klaus, 38304 Wolfenbuettel (DE)

(56) Entgegenhaltungen:
- EP-A- 0 601 410
- EP-A- 0 789 451
- US-A- 4 268 797

## Beschreibung

### Stand der Technik

Die Erfindung geht von einem Verfahren und von einer Schaltungsanordnung zur Arbeitspunkteinstellung einer Transistorstufe nach der Gattung der unabhängigen Ansprüche 1 und 2 aus.

Aus der neunten Auflage von Halbleiterschaltungstechnik", U. Tietze und Ch. Schenk, Springer-Verlag Berlin, ist auf Seite 49 ein Verfahren und eine Schaltungsanordnung zur Arbeitspunkteinstellung bei Bipolartransistoren bekannt. Dabei wird die Basisspannung aus der Betriebsspannung erzeugt und die Signalwechselspannung über einen Kondensator eingekoppelt.

Die EP-A-0 789 451 A1 offenbart eine Hochfrequenzverstärkeranordnung, in der eine Transistorstufe vorgesehen ist. Diese hat einen ersten Eingang bzw. einen Steuereingang, an dem durch eine Arbeitspunktsteuerschaltung eine Vorspannung zur Einstellung eines Arbeitspunkts der Transistorstufe bereitgestellt wird. An einem zweiten Eingang wird der Transistorstufe über einen Schalter einer Versorgungsspannung zugeführt. Schließlich wird über einen dritten Eingang ein zu verstärkendes Eingangssignal eingespeist, das bei einem Ausgang wieder herausgeleitet wird. Der Transistorstufe wird dabei über den Schalter nur dann die Versorgungsspannung zugeführt, wenn zuvor eine Vorspannung durch die Arbeitspunktsteuerschaltung am Steuereingang bereitgestellt wird.

Es ist die Aufgabe der vorliegenden Erfindung, ein Verfahren zu schaffen, durch das der Arbeitspunkt einer Transistorstufe mit minimiertem verfahrens- und vorrichtungstechnischen Aufwand einstellbar ist.

Diese Aufgabe wird hinsichtlich des Verfahrens durch die Merkmale des Anspruchs 1 gelöst.

### Vorteile der Erfindung

Das erfindungsgemäße Verfahren mit den Merkmalen des unabhängigen Anspruchs 1 hat demgegenüber den Vorteil, daß eine kostspielige und aufwendige Spannungsversorgung für die Arbeitspunkteinstellung entfallen kann. Dies ist vor allem bei GaAs-Feldeffekttransistorstufen von Vorteil, die eine negative Spannungsversorgung am Gate-Eingang erfordern, um eine Beschädigung des Bausteins durch einen hohen Sättigungsstrom zu verhindern.

Ein weiterer Vorteil besteht darin, daß einem Steuereingang der Transistorstufe spätestens beim Einschalten einer Versorgungsspannung kurzzeitig eine Vorspannung aufgeprägt wird. Auf diese Weise wird bei fehlendem Eingangspegel ein definierter Arbeitspunkt eingestellt, der den maximalen Strom begrenzt. Durch die zusätzlich aufgeprägte Vorspannung wird außerdem der stabile Ansteuerbereich erweitert, wodurch eine höhere Streuung für den Eingangspegel der Gesamtschaltung zulässig ist.

Vorteilhaft ist auch, daß durch Aufprägen der Vorspannung das Eingangssignal nicht vor dem Anlegen der Versorgungsspannung, bzw. bei Verwendung eines Feldeffekttransistors nicht vor dem Anlegen der Drain-Source-Spannung zugeschaltet werden muß, um einen stabilen Arbeitspunkt beim Einschalten der Versorgungsspannung zu erhalten und eine Beschädigung des Bausteins durch starke Stromspitzen zu vermeiden. Dadurch kann die Versorgungsspannung und das Eingangssignal in einem einzigen Schaltvorgang zugeschaltet werden, wofür ein einziges Steuersignal ausreicht.

Desweiteren ist vorteilhaft daß durch die Ableitung der Vorspannung aus der Ladung des Energiespeichers nur die für die Anlaufphase erforderliche Energie zur Verfügung gestellt werden muß, um den Steuereingang der Transistorstufe vorzuspannen, so daß eine gute Leistungsbilanz erzielt wird.

Durch die in den abhängigen Ansprüchen aufgeführten Maßnahmen sind vorteilhafte Weiterbildungen und

### Verbesserungen der Erfindung möglich.

Besonders vorteilhaft ist es, daß das zweite Steuersignal vom ersten Steuersignal abgeleitet ist. Auf diese Weise ist nur ein einziges Steuersignal erforderlich und keine Synchronisation der beiden Steuersignale notwendig.

Ein weiterer Vorteil besteht darin, daß das zweite Steuersignal gegenüber dem ersten Steuersignal zeitlich verzögert ist. Auf diese Weise wird sichergestellt, daß zum Zeitpunkt des Einschaltens der Versorgungsspannung ein definierter und stabiler Arbeitspunkt eingestellt ist.

Besonders vorteilhaft ist auch, daß die Transistorstufe mindestens einen GaAs-Feldeffekttransistor umfaßt, dessen Steuereingang ein hochohmiger Gate-Eingang ist. Auf diese Weise kann der Energiespeicher sehr klein ausgelegt werden, da seine Ladung nur unwesentlich über den Gate-Eingang abfließen kann.

Vorteilhaft ist weiterhin, daß ein Spannungsinverter vorgesehen ist, der mindestens einen vom ersten Steuersignal gesteuerten Schalter umfaßt, und daß der gesteuerte Schalter den geladenen Energiespeicher so an den Gate-Eingang anschließt, daß die dort anliegende Vorspannung negativ ist. Somit ist eine einfache Möglichkeit gegeben, mit üblichen negativen Spannungswandlern die erforderliche Vorspannung an den Gate-Eingang anzuschließen.

### Zeichnung

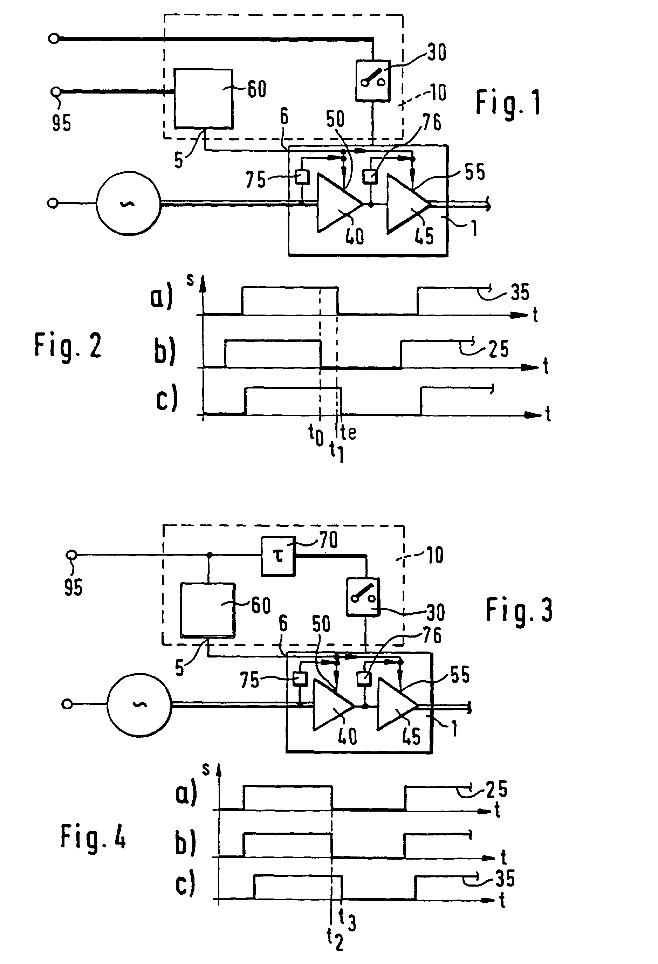

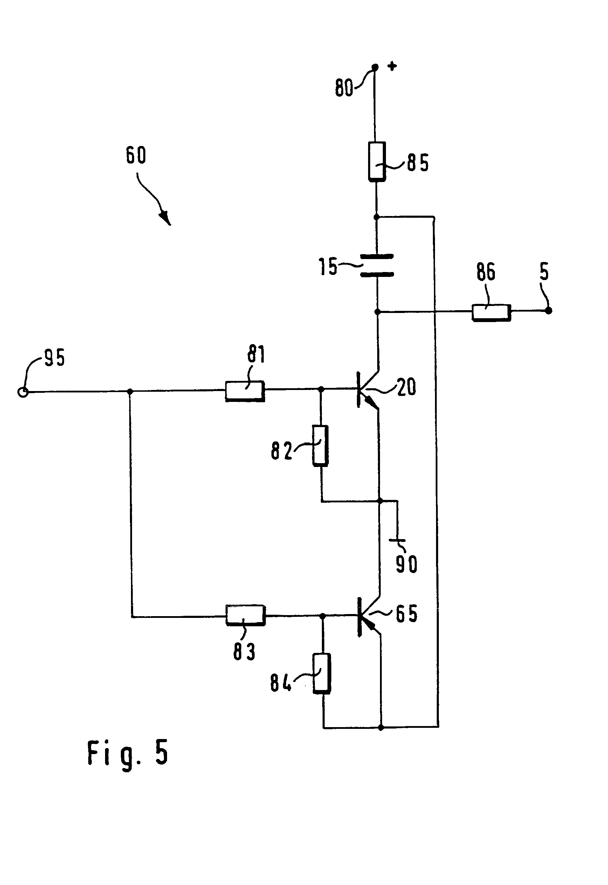

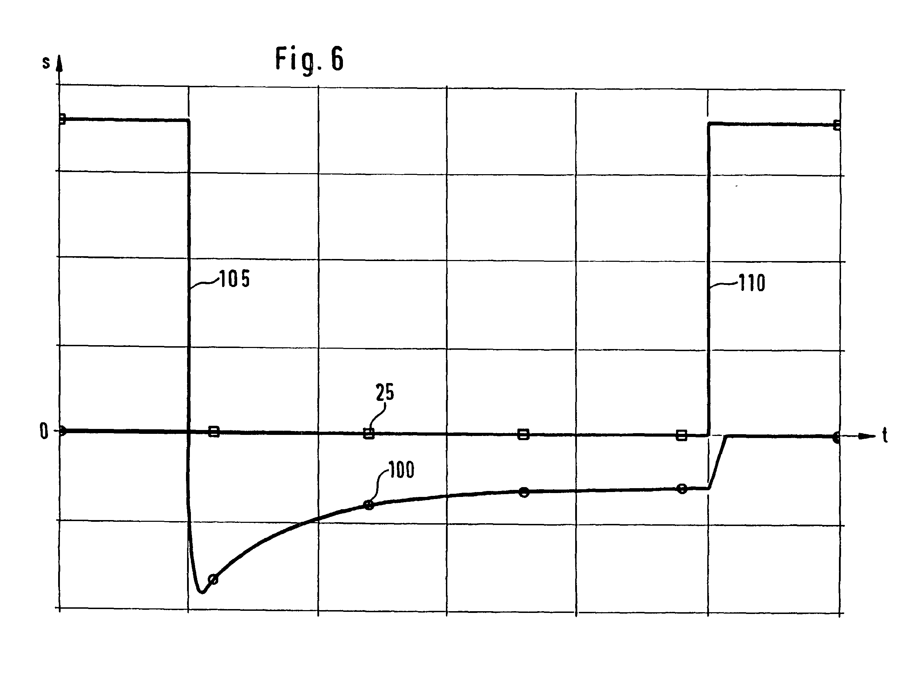

Ausführungsbeispiele der Erfindung sind in der Zeichnung dargestellt und in der nachfolgenden Beschreibung näher erläutert. Es zeigen Figur 1 ein Blockschaltbild einer ersten erfindungsgemäßen Schaltungsanordnung, Figur 2 einen Impulsfahrplan zur Veranschaulichung der Wirkungsweise der Schaltungsanordnung gemäß Figur 1, Figur 3 ein Blockschaltbild einer zweiten erfindungsgemäßen Schaltungsanordnung, Figur 4 einen Impulsfahrplan zur Darstellung der Wirkungsweise der Schaltungsanordnung gemäß Figur 3, Figur 5 eine Schaltungsanordnung zur Erzeugung der erforderlichen Vorspannung und Figur 6 einen zeitlichen Verlauf einer solchen Vorspannung.

### Beschreibung der Ausführungsbeispiele

In Figur 1 kennzeichnet 10 eine Schaltungsanordnung zur Arbeitspunkteinstellung einer Transistorstufe 1, die einen ersten GaAs-Feldeffekttransistor 40 und einen zweiten GaAs-Feldeffekttransistor 45 umfaßt. Die Schaltungsanordnung 10 umfaßt einen Spannungsinverter 60, dem ein erstes Steuersignal 25 zugeführt ist und einen zweiten steuerbaren Schalter 30, dem ein zweites Steuersignal 35 zugeführt ist. Über den zweiten steuerbaren Schalter 30 kann an die beiden Feldeffekttransistoren 40, 45 eine Drain-Source-Spannung angelegt werden. Der Spannungsinverter 60 ist über einen Steuereingang 6 der Transistorstufe 1 mit einem Steuereingang 50 des ersten Feldeffekttransistors 40 und mit einem Steuereingang 55 des zweiten Feldeffekttransistors 45 verbunden. Bei den beiden Steuereingängen 50, 55 handelt es sich dabei jeweils um einen Gate-Eingang. Der Transistorstufe 1 ist ein hochfrequentes Eingangssignal zugeführt. Das hochfrequente Eingangssignal ist außerdem über einen ersten Gleichrichter 75 ebenfalls dem Gate-Eingang 50 des ersten Feldeffekttransistors 40 zugeführt. Das Ausgangssignal des ersten Feldeffekttransistors 40 bildet das Eingangssignal des zweiten Feldeffekttransistors 45 und ist außerdem über einen zweiten Gleichrichter 76 dem Steuereingang 55 des zweiten Feldeffekttransistors 45 zugeführt.

In Figur 2 ist ein Impulsfahrplan für die Beschreibung der Wirkungsweise der Schaltungsanordnung 10 gemäß Figur 1 dargestellt. Im Impulsfahrplan sind die Signale als Amplitude s über der Zeit t dargestellt. Dabei wird dem Spannungsinverter 60 das erste Steuersignal 25 zugeführt, das impulsförmig ist und zu einem ersten Zeitpunkt t₀ gemäß Figur 2b) eine fallende Flanke aufweist. Zu einem zweiten Zeitpunkt t₁, der gegenüber dem ersten Zeitpunkt t₀ zeitlich verzögert ist, weist auch das zweite Steuersignal 35, das dem zweiten steuerbaren Schalter 30 zugeführt und ebenfalls impulsförmig ist, eine fallende Flanke gemäß Figur 2a) auf. Gegenüber dem zweiten Zeitpunkt t₁ zeitlich verzögert, wird gemäß Figur 2c) durch eine fallende Impulsflanke das hochfrequente Eingangssignal zu einem Einschaltzeitpunkt tₑ eingeschaltet. Das Einschalten des hochfrequenten Eingangssignals kann jedoch auch bereits zum zweiten Zeitpunkt t₁ erfolgen. Durch die fallende Flanke des ersten Steuersignals 25 wird zum ersten Zeitpunkt t₀ über den Spannungsinverter 60 den Gate-Eingängen 50, 55 eine Vorspannung aufgeprägt, wodurch an den beiden Feldeffekttransistoren 40, 45 ein definierter und stabiler Arbeitspunkt eingestellt wird. Die vom Spannungsinverter 60 gelieferte Vorspannung ist dabei negativ, so daß der maximale Strom im jeweiligen Feldeffekttransistor 40, 45 begrenzt wird und eine Beschädigung des jeweiligen Bausteins vermiedene wird. Durch die negative Vorspannung des Spannungsinverters 60 wird der stabile Ansteuerbereich der beiden Feldeffekttransistoren 40, 45 in Richtung kleinerer Eingangspegel erweitert, wodurch eine höhere Streuung des Eingangspegels der Gesamtschaltung zulässig ist. Zum zweiten Zeitpunkt t₁ liegt also ein definierter und stabiler Arbeitspunkt an den beiden Feldeffekttransistoren 40, 45 vor, so daß die Drain-Source-Spannung über den zweiten steuerbaren Schalter 30 durch die fallende Flanke des zweiten Steuersignals 35 eingeschaltet werden kann und gleichzeitig bzw. kurz darauf auch das hochfrequente Eingangssignal der Transistorstufe 1 zugeführt werden kann. Die Erzeugung der negativen Vorspannung zur Arbeitspunkteinstellung wird dann durch die am Eingang der Transistorstufe 1 angelegte Signalleistung des hochfrequenten Eingangssignals für den ersten Feldeffekttransistor 40, und durch die Signalleistung des hochfrequenten Ausgangssignals des ersten Feldeffekttransistors 40 für den zweiten Feldeffekttransistor 45 übernommen. Die jeweils erforderliche negative Gate-Vorspannung zur Arbeitspunkteinstellung wird dabei für den ersten Feldeffekttransistor 40 mittels des ersten Gleichrichters 75 und für den zweiten Feldeffekttransistor 45 mittels des zweiten Gleichrichters 76 erzeugt.

Figur 3 zeigt eine weitere Ausführungsform der erfindungsgemäßen Schaltungsanordnung. Dabei kennzeichnen gleiche Bezugszeichen gleiche Elemente wie in Figur 1. Im Unterschied zum Ausführungsbeispiel gemäß Figur 1 ist nur ein einziges Steuersignal 25 erforderlich, das dem Spannungsinverter 60 und einem Verzögerungsglied 70 zugeführt ist. Das Verzögerungsglied 70 ist über den zweiten steuerbaren Schalter 30 mit der Transistorstufe 1 zur Einstellung der Drain-Source-Spannung für die Feldeffekttransistoren 40, 45 verbunden. Somit wird durch das Verzögerungsglied 70 aus dem ersten Steuersignal 25 das zweite Steuersignal 35 abgeleitet.

Figur 4 zeigt einen Impulsfahrplan zur Darstellung der Wirkungsweise der Schaltungsanordnung 10 gemäß Figur 3. Dabei wird die Funktionsweise der Schaltungsanordnung 10 gemäß Figur 3 auch bereits durch den Impulsfahrplan gemäß Figur 2 beschrieben, wobei die Verzögerung des zweiten Steuersignals 35 gegenüber dem ersten Steuersignal 25 durch das Verzögerungsglied 70 bewirkt wird. Genauso ist auch der Impulsfahrplan gemäß Figur 4 auf die Schaltungsanordnung 10 gemäß Figur 1 anwendbar, wobei dann jedoch das zweite Steuersignal 35 nicht aus dem ersten Steuersignal 25 abgeleitet wird. Gemäß dem Impulsfahrplan nach Figur 4 sind wieder die Amplituden s der einzelnen Signale über der Zeit t aufgetragen. Dabei weist das impulsförmige erste Steuersignal 25 zu einem dritten Zeitpunkt t₂ eine fallende Flanke gemäß Figur 4a) auf. Gemäß Figur 4b) wird zum selben Zeitpunkt t₂ das hochfrequente Eingangssignal eingeschaltet. Zu einem gegenüber dem dritten Zeitpunkt t₂ zeitlich durch das Verzögerungsglied 70 verzögerten vierten Zeitpunkt t₃ weist das impulsförmige zweite Steuersignal 35 eine fallende Flanke gemäß Figur 4c) auf. Somit ist auch beim Impulsfahrplan gemäß Figur 4 gewährleistet, daß die Drain-Source-Spannung der Feldeffekttransistoren 40, 45 erst dann eingeschaltet wird, wenn bereits durch eine Vorspannung ein definierter und stabiler Arbeitspunkt an den beiden Gate-Eingängen 50, 55 anliegt. Eine Verzögerung des zweiten Steuersignals 35 wäre dabei jedoch nicht unbedingt erforderlich, da es bereits ausreicht, wenn im Einschaltzeitpunkt der Drain-Source-Spannung eine definierte Vorspannung an den beiden Gate-Eingängen 50, 55 anliegt. Dies ist entweder dann gegeben, wenn der Einschaltzeitpunkt des hochfrequenten Eingangssignals dem Einschaltzeitpunkt der Drain-Source-Spannung vorauseilt oder wenn die fallende Flanke des ersten Steuersignals 25 spätestens mit der fallenden Flanke des zweiten Steuersignals 35 vorliegt.

Gemäß Figur 5 ist eine Schaltungsanordnung für den Spannungsinverter 60 angegeben. Der in den Figuren 1 und 3 mit dem Bezugszeichen 95 gekennzeichnete Eingang der Schaltungsanordnung 10 für das erste Steuersignal 25 ist auch in Figur 5 mit dem Bezugszeichen 95 gekennzeichnet. Der in den Figuren 1 und 3 mit dem Bezugszeichen 5 gekennzeichnete Ausgang des Spannungsinverters 60 ist auch in Figur 5 mit dem Bezugszeichen 5 gekennzeichnet und mit dem Steuereingang 6 der Transistorstufe 1 gemäß Figur 1 und Figur 3 verbunden. Der Steuersignaleingang 95 ist über einen ersten Widerstand 81 mit der Basis eines npn-Bipolartransistors 20 verbunden, dessen Emitter an ein Bezugspotential 90 angeschlossen ist und über einen zweiten Widerstand 82 ebenfalls mit der Basis des npn-Bipolartransistors 20 verbunden ist. Der Steuersignaleingang 95 ist außerdem über einen dritten Widerstand 83 mit der Basis eines pnp-Bipolartransistors 65 verbunden, dessen Emitter über einen vierten Widerstand 84 mit der Basis des pnp-Bipolartransistors 65 verbunden ist und dessen Kollektor an das Bezugspotential 90 angeschlossen ist. Der Kollektor des npn-Bipolartransistors 20 ist über einen als Kondensator ausgebildeten Energiespeicher 15 und einen fünften Widerstand 85 mit einem Versorgungsspannungspotential 80 verbunden. Zwischen dem Kondensator 15 und dem fünften Widerstand 85 ist außerdem der Emitter des pnp-Bipolartransistors 65 angeschlossen. Der Kollektor des npn-Bipolartransistors 20 ist über einen sechsten Widerstand 86 mit dem Ausgang 5 des Spannungsinverters 60 verbunden.

Die Funktionsweise der Schaltung wird durch den in Figur 6 dargestellten Signalverlauf erläutert. Dabei ist die Amplitude s des ersten Steuersignals 25 und eines Ausgangssignals 100 des Spannungsinverters 60 über der Zeit t dargestellt. Das erste Steuersignal 25 liegt dabei am Steuersignaleingang 95 an und das Ausgangssignal 100 liegt am Ausgang 5 des Spannungsinverters 60 an. Dabei hat das erste Steuersignal 25 zunächst einen hohen Pegel, so daß der npn-Bipolartransistor 20 leitet und der pnp-Bipolartransistor 65 sperrt. Dadurch liegt am Kollektor des npn-Bipolartransistors 20 annähernd das Bezugspotential 90. Der Ausgang 5 des Spannungsinverters 60 weist somit zunächst keine Spannung auf. Mit einer fallenden Flanke 105 des ersten Steuersignals 25 geht der npn-Bipolartransistor 20 in den gesperrten Zustand über, das heißt, er wird hochohmig. Außerdem wird der pnp-Bipolartransistor 65 leitend, so daß das Bezugspotential 90 annähernd zwischen dem Kondensator 15 und dem fünften Widerstand 85 anliegt. Dadurch erfolgt eine Klappwandlung am Kondensator 15, so daß gemäß Figur 6 das Ausgangssignal 100 negativ wird und somit eine negative Vorspannung am Ausgang 5 des Spannungsinverters 60 anliegt, die in kurzer Zeit einen betragsmäßig hohen Wert einnimmt und dann logarithmisch betragsmäßig abnimmt. Erst mit der nächsten ansteigenden Flanke 110 des Steuersignals 25 wird der npn-Bipolartransistor 20 wieder leitend und der pnp-Bipolartransistor 65 gesperrt, so daß das Ausgangssignal 100 wieder in den vorherigen Zustand einschwingt und am Ausgang 5 des Spannungsinverters 60 annähernd das Bezugspotential 90 anliegt, das in Figur 6 den Wert 0 aufweist.

Die innerhalb kurzer Zeit nach der fallenden Flanke des ersten Steuersignals 25 erzeugte negative Vorspannung am Ausgang 5 des Spannungsinverters 60 genügt bereits, um die Transistorstufe 1 mit den beiden Feldeffekttransistoren 40, 45 in einen stabilen Arbeitspunkt zu bringen. Da der jeweilige Gate-Eingang 50, 55 hochohmig ist, genügt bereits eine geringe Ladung des Kondensators 15, da der Kondensator 15 nur unwesentlich über den jeweiligen Gate-Eingang 50, 55 entladen werden kann.

Nach dem Einschalten der Drain-Source-Spannung des jeweiligen Feldeffekttransistors 40, 45 durch den zweiten steuerbaren Schalter 30 wird der Arbeitspunkt des jeweiligen Feldeffekttransistors 40, 45 dann überwiegend aus dem gleichgerichteten Eingangssignal des jeweiligen Feldeffekttransistors 40, 45 abgeleitet. Die Vorspannung liegt gemäß Figur 6 nur für kurze Zeit mit ausreichendem Betrag an den beiden Gate-Eingängen 50, 55 an, wobei in dieser kurzen Zeit durch die Vorspannung ein definierter und stabiler Arbeitspunkt eingestellt wird. Ohne Gate-Vorspannung ist die Drain-Source-Strecke des jeweiligen Feldeffekttransistors 40, 45 niederohmig, so daß starke Stromspitzen auftreten können. Durch die beschriebene stabile Arbeitspunkteinstellung mittels der Vorspannung wird verhindert, daß der für die Transistorstufe 1 relativ undefinierte Einschaltvorgang, der durch kurzzeitige Oszillationen und sehr starke Stromspitzen auf der Versorgungsspannung charakterisiert sein kann, starke Abstrahlungen unerwünschter Frequenzen oder eine starke Beeinflussung anderer Baugruppen durch die Impulse auf der Spannungsversorgung verursacht. Durch das erfindungsgemäße Verfahren und die erfindungsgemäße Schaltungsanordnung 10 ist es zur Verhinderung dieser schädlichen Auswirkungen des Einschaltvorgangs nicht erforderlich, die Eingangsleistung des hochfrequenten Eingangssignals bereits vor dem Anlegen der Drain-Source-Spannung zuzuschalten, um auf diese Weise rechtzeitig aus dem Eingangssignal einen stabilen und definierten Arbeitspunkt zu erhalten. Das Eingangssignal kann somit beim erfindungsgemäßen Verfahren und der erfindungsgemäßen Schaltungsanordnung 10 gleichzeitig mit der Drain-Source-Spannung angelegt werden, so daß der gesamte Einschaltvorgang vereinfacht wird, zumal nur ein einziges Steuersignal erforderlich ist.

Befindet sich die Transistorstufe 1 mittels der Vorspannung in einem stabilen und definierten Arbeitspunkt, so bleibt sie in einem stabilen und definierten Arbeitspunkt durch eine Selbstregelung des Arbeitspunktes mittels des hochfrequenten Eingangssignals des jeweiligen Feldeffekttransistors 40, 45.

Das erfindungsgemäße Verfahren und die erfindungsgemäße Schaltungsanordnung lassen sich ganz allgemein auf alle GaAs-Bausteine, beispielsweise auf Mischer oder Sendeendstufen in gebursteten Systemen mit impulsförmigen Steuersignalen anwenden. Dabei kann es sich bei der Transistorstufe 1 um eine HF-Endstufe, insbesondere in schnurlosen Telefonen beispielsweise nach dem DECT-Standard (Digital European Cordless Telephone) oder in Mobiltelefonen beispielsweise nach dem GSM-Standard (Global System for mobile communications) handeln.

Die beschriebene Spannungsinversion mittels des Spannungsinverters 60 ist ebenfalls nur beispielhaft beschrieben und kann durch andere übliche negative Spannungswandler ersetzt werden.

Aus dem ersten bzw. dem zweiten Steuersignal 25, 35 kann auch das Einschaltsignal für das hochfrequente Eingangssignal abgeleitet werden. Der Einschaltzeitpunkt für das hochfrequente Eingangssignal ist bei der erfindungsgemäßen Schaltungsanordnung bzw. dem erfindungsgemäßen Verfahren unabhängig vom Einschaltzeitpunkt der Versorgungsspannung bzw. der Drain-Source-Spannung. Wird das hochfrequente Eingangssignal vor Anlegen der Drain-Source-Spannung eingeschaltet, so trägt es zur Bildung eines stabilen und definierten Arbeitspunktes beim Einschalten der Drain-Source-Spannung bei. Wird das hochfrequente Eingangssignal mit der Drain-Source-Spannung oder nach der Drain-Source-Spannung eingeschaltet, so ist aufgrund der Vorspannung zum Zeitpunkt des Einschaltens der Drain-Source-Spannung ebenfalls ein stabiler und definierter Arbeitspunkt vorhanden.

Die Erfindung ist nicht auf Transistorstufen mit Feldeffekttransistoren beschränkt, sondern für beliebige Transistorstufen anwendbar, bei denen undefinierte Einschaltzustände auftreten. Je nach Art der verwendeten Transistoren kann die erforderliche Vorspannung auch positiv sein.

## Patentansprüche

1. Verfahren zur Einstellung eines Arbeitspunktes einer Transistorstufe (1) umfassend einen Steuereingang (6) zum Anlegen einer Vorspannung, einen Versorgungsspannungseingang zum Anlegen einer Versorgungsspannung für die Transistorstufe und einen Signaleingang zum Anlegen eines Nutzsignals, wobei dem Steuereingang (6) der Transistorstufe (1) spätestens beim Anlegen einer Versorgungsspannung an den Versorgungsspannungseingang der Transistorstufe (1) eine Vorspannung mit ausreichendem Betrag für eine derart kurze Zeit aufgeprägt wird, um einen definierten Arbeitspunkt einzustellen,
wobei der Arbeitspunkt nach Anlegen der Versorgungsspannung der Transistorstufe (1) aus einem an dem Signaleingang der Transistorstufe (1) angelegten Nutzsignal nach Gleichrichtung desselben abgeleitet wird, und
wobei die Vorspannung der Transistorstufe (1) zum Einstellen eines definierten Arbeitspunkts aus einer Ladung eines geladenen Energiespeichers (15) abgeleitet wird,
**dadurch gekennzeichnet, dass**
mindestens einem steuerbaren Schalter (20) ein erstes Steuersignal zugeführt wird, wobei in Abhängigkeit des ersten Steuersignals (25) der Energiespeicher (15) durch den mindestens einen steuerbaren Schalter (20) an den Steuereingang (6) der Transistorstufe (1) angeschaltet wird, so dass die Vorspannung am Steuereingang (6) anliegt.

2. Verfahren nach Anspruch 1, bei dem der Energiespeicher (15) ein Kondensator ist.

3. Verfahren nach Anspruch 1 oder 2, bei dem die Versorgungsspannung über einen weiteren steuerbaren Schalter (30) ansprechend auf ein zweites Steuersignal (35) eingeschaltet wird.

4. Verfahren nach Anspruch 3, bei dem das zweite Steuersignal (35) vom ersten Steuersignal (25) abgeleitet wird.

5. Verfahren nach Anspruch 3 oder 4, bei dem das zweite Steuersignal (35) gegenüber dem ersten Steuersignal (25) zeitlich verzögert wird.

6. Verfahren nach einem der Ansprüche 1 bis 5, bei dem die Transistorstufe (1) mindestens einen GaAs-Feldeffekttransistor (40, 45) umfasst, dessen Steuereingang (50, 55) ein hochohmiger Gate-Eingang ist, und dass die am Gate-Eingang (50, 55) kurzzeitig anliegende Vorspannung negativ ist.

7. Verfahren nach Anspruch 6, bei dem ein Spannungsinverter (60) vorgesehen wird, der mindestens einen vom ersten Steuersignal (25) gesteuerten Schalter (65) umfasst, wobei der geladenen Energiespeicher (15) durch den mindestens einen vom ersten Steuersignal (25)gesteuerten Schalter (65) so an den Gate-Eingang (50, 55) angeschlossen wird, dass die dort anliegende Vorspannung negativ ist.

8. Verfahren nach einem der Ansprüche 1 bis 7, bei dem die Transistorstufe (1) als HF-Endstufe, insbesondere eines schnurlosen oder Mobiltelefons, ausgebildet ist.

## Claims

1. Method for biasing a transistor stage (1) comprising a control input (6) for applying a bias voltage, a supply voltage input for applying a supply voltage for the transistor stage, and a signal input for applying a wanted signal, where a bias voltage having sufficient amplitude for a short time is applied to the control input (6) of the transistor stage (1) when a supply voltage is applied to the supply voltage input of the transistor stage (1) at the latest so as to bias the transistor stage at a defined operating point,
where the operating point is derived after applying the supply voltage of the transistor stage (1) from a wanted signal applied to the signal input of the transistor stage (1) after rectifying said wanted signal, and
where the bias voltage for biasing the transistor stage (1) at a defined operating point is derived from a charge of a charged energy storage device (15),
**characterized in that**
a first control signal is fed to at least one controllable switch (20), where as a function of the first control signal (25) the energy storage device (15) is connected by the at least one controllable switch (20) to the control input (6) of the transistor stage (1) so that the bias voltage is applied to the control input (6).

2. Method according to Claim 1, in which the energy storage device (15) is a capacitor.

3. Method according to Claim 1 or 2, in which the supply voltage is switched on via a further controllable switch (30) in response to a second control signal (35).

4. Method according to Claim 3, in which the second control signal (35) is derived from the first control signal (25).

5. Method according to Claim 3 or 4, in which the second control signal (35) is delayed with respect to the first control signal (25).

6. Method according to one of Claims 1 to 5, in which the transistor stage (1) comprises at least one GaAs field effect transistor (40, 45) whose control input (50, 55) is a high-impedance gate input, and the bias voltage applied briefly to the gate input (50, 55) is negative.

7. Method according to Claim 6, in which a voltage inverter (60) is provided, which comprises at least one switch (65) controlled by the first control signal (25), where the charged energy storage device (15) is connected by the at least one switch (65) controlled by the first control signal (25) to the gate input (50, 55) so that the bias voltage applied there is negative.

8. Method according to one of Claims 1 to 7, in which the transistor stage (1) is designed as an HF output stage, in particular of a cordless telephone or mobile phone.

## Revendications

1. Procédé pour le réglage d'un point de fonctionnement d'un étage à transistor (1) comprenant une entrée de commande (6) pour l'application d'une tension de polarisation, une entrée de tension d'alimentation pour l'application d'une tension d'alimentation pour l'étage à transistor et une entrée de signal pour l'application d'un signal utile, une tension de polarisation de valeur suffisante étant appliquée à l'entrée de commande (6) de l'étage à transistor (1) au plus tard lors de l'application d'une tension d'alimentation à l'entrée de tension d'alimentation de l'étage à transistor (1), pour un temps assez court pour régler un point de fonctionnement défini,
le point de fonctionnement étant dérivé, après l'application de la tension d'alimentation de l'étage à transistor (1), d'un signal utile appliqué à l'entrée de signal de l'étage à transistor (1) après redressement de ce même signal et
la tension de polarisation de l'étage à transistor (1) pour le réglage d'un point de fonctionnement défini étant dérivée d'une charge d'un accumulateur d'énergie (15) chargé,
**caractérisé en ce que**
un premier signal de commande est amené à au moins un interrupteur commandable (20), l'accumulateur d'énergie (15) étant connecté à l'entrée de commande (6) de l'étage à transistor (1) grâce à l'au moins un interrupteur commandable (20) en fonction du premier signal de commande (25), de manière à ce que la tension de polarisation soit appliquée à l'entrée de commande (6).

2. Procédé selon la revendication 1, dans lequel l'accumulateur d'énergie (15) est un condensateur.

3. Procédé selon la revendication 1 ou 2, dans lequel la tension d'alimentation est enclenchée par le biais d'un autre interrupteur commandable (30) sensible à un deuxième signal de commande (35).

4. Procédé selon la revendication 3, dans lequel le deuxième signal de commande (35) est dérivé du premier signal de commande (25).

5. Procédé selon la revendication 3 ou 4, dans lequel le deuxième signal de commande (35) est retardé dans le temps par rapport au premier signal de commande (25).

6. Procédé selon l'une des revendications 1 à 5, dans lequel l'étage à transistor (1) comprend au moins un transistor à effet de champ GaAs (40, 45) dont l'entrée de commande (50, 55) est une entrée de porte à haute impédance et dans lequel la tension de polarisation brièvement appliquée à l'entrée de porte (50, 55) est négative.

7. Procédé selon la revendication 6, dans lequel on prévoit un inverseur de tension (60) qui comprend au moins un interrupteur (65) commandé par le premier signal de commande (25), l'accumulateur d'énergie (15) chargé étant connecté à l'entrée de porte (50, 55) grâce à l'au moins un interrupteur (65) commandé par le premier signal de commande (25) de manière à ce que la tension de polarisation appliquée à l'entrée de porte soit négative.

8. Procédé selon l'une des revendications 1 à 7, dans lequel l'étage à transistor (1) est exécuté en tant qu'étage de sortie haute fréquence, notamment d'un téléphone sans fil ou téléphone mobile.
